# EUROPEAN PATENT APPLICATION

(11) **EP 3 288 145 A1**
(43) Date of publication of application: **28.02.2018**
(21) Application number: 16185499.7
(22) Date of filing: 24.08.2016
(51) Int. Cl.: H02J 7/00, B66B 5/02, G01R 31/36

(54) **METHOD AND SYSTEM FOR MONITORING THE CHARGING STATE OF A BATTERY**

(71) Applicant: Otis Elevator Company, Farmington CT 06032 (US)
(72) Inventor: SPIELBAUER, Hans-Kilian, 13507 Berlin (DE); COMINELLI, Donald F., 13507 Berlin (DE); PETERS, Michael, 13507 Berlin (DE)
(74) Representative: Schmitt-Nilson Schraud Waibel Wohlfrom Patentanwälte Partnerschaft mbB

(57) **Abstract**

An electrical system (2) comprises a battery (26) for storing electrical energy; a battery monitoring device (22) which is configured for determining a numerical value representing the charging state of the battery (26) by setting an initial numerical value representing the charging state of the battery (26); and repeatedly determining a current operational state of the electrical system (2) and a time period (T₁ - T₁₀) for which said current operational state is active; calculating a change of the charging state of the battery (26) as a function of the determined current operational state of the electrical system (2) and the time period (T₁ - T₁₀) for which said current operational state is active; and updating the numerical value representing the charging state of the battery (26) by adding or subtracting the calculated change of the charging state to/from the numerical value.

## Description

The invention relates to a method and to a system for monitoring the charging state of a battery in an electrical system, in particular in an elevator system, more particular, in an elevator alarm/rescue system.

Safety related electrical systems such as elevator alarm/rescue systems must be able to operate for a specific period of time even in case of power failure. Such systems therefore usually comprise a battery which is configured for providing electrical power for operating the elevator alarm/rescue system in case the external power supply breaks down. In order to allow for safe operation of the elevator system, the elevator system should be operated only as long as the battery comprises enough electrical charge for ensuring a safe operation of the elevator alarm/rescue system for at least a predetermined period of time which allows to bring the elevator system into a safe condition in which no passengers are trapped within the elevator car. Current safety standards require ensuring a safe operation of the elevator alarm/rescue system for at least one hour.

It therefore would be beneficial to provide a method and means for determining the charging status of the battery at any point of time ("current charging status") with sufficient accuracy at low costs.

According to an exemplary embodiment of the invention, a method of monitoring a charging state of a battery in an electrical system comprises the steps of: setting a numerical value representing the charging state of the battery to an initial value; repeatedly determining a current operational state of the electrical system and a time period for which said operational state is active; repeatedly calculating a change of the charging state as a function of the determined operational state of the electrical system and the time period for which said operational state is active; and repeatedly updating the numerical value representing the charging state of the battery by adding or subtracting the calculated change of the charging state to/from the numerical value.

According to an exemplary embodiment of the invention an electrical system comprises a battery for storing electrical energy; a battery monitoring device which is configured for determining a numerical value representing the charging state of the battery by setting a numerical value representing the charging state of the battery to an initial value; by repeatedly determining a current operational state of the electrical system and a time period for which said operational state is active; by repeatedly calculating a change of the charging state as a function of the determined operational state of the electrical system and the time period for which said operational state is active; and by repeatedly updating the numerical value representing the charging state of the battery by adding or subtracting the calculated change of the charging state to/from the numerical value.

According to exemplary embodiments of the invention the charging state of the battery is evaluated by monitoring the charging and discharging operations of the battery and calculating the charging state within the battery from said information. The system in particular is in the charging state, when connected to an external power supply and the battery is charged; and the system is in a discharging state when no external power is supplied to the electrical system and the electrical system is operated using power from the battery. A numerical value representing an estimated charge is added in the charging state and a numerical value representing an estimated charge is subtracted in the discharging state.

Exemplary embodiments of the invention allow to determine the current charging state of the battery without reducing the available charge and with high accuracy, in particular with a higher accuracy than prior art methods which are based on the curve characteristic of the battery voltage.

Exemplary embodiments of the invention will be described in more detail with respect to the enclosed figures:
Figure 1 depicts an elevator system comprising an electrical system according to an exemplary embodiment of the invention.
Figure 2 depicts a graph illustrating different charging and discharging operations of the battery.

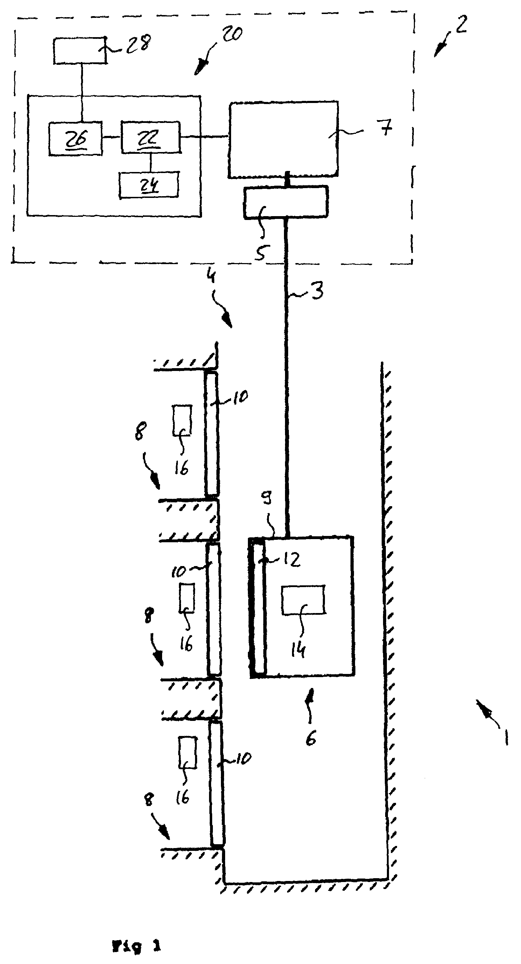

Figure 1 depicts an elevator system 1 comprising an electrical system according to an exemplary embodiment of the invention.

The elevator system 1 includes an elevator car 6 which is movably suspended within a hoistway 4 by means of a tension member 3. The tension member 3, for example a rope or belt, is connected to an elevator drive 5, which is configured for driving the tension member 3 in order to move the elevator car 6 along the height of the hoistway 4 between a plurality of landings 8 located on different floors.

Each landing 8 is provided with a landing door 10, and the elevator car 6 is provided with a corresponding elevator car door 12 for allowing passengers to transfer between a landing 8 and the interior of the elevator car 6 when the elevator car 6 is positioned at the respective landing 8.

The exemplary embodiment shown in Figure 1 uses a 1:1 roping for suspending the elevator car 6. The skilled person, however, easily understands that the type of the roping is not essential for the invention and that different kinds of roping, e.g. a 2:1 roping or none at all, may be used as well. The elevator system 1 may use a counterweight (not shown) or not. The elevator drive 5 may be any form of drive used in the art, e.g. a traction drive, a hydraulic drive or a linear drive. The elevator system 1 may have a machine room or may be a machine room-less elevator system. The elevator system 1 may use a tension member 3, as it is shown in Figure 1, or it may be an elevator system without a tension member 3.

The elevator drive 5 is controlled by an elevator control unit 7 for moving the elevator car 6 between the different landings 8.

Input to the control unit 7 may be provided via an elevator car control panel 14 provided inside the elevator car 6 and/or landing control panels 16, which are provided close to the landing doors 10 on each landing 8.

The elevator car control panel 14 and the landing control panels 16 may be connected to the elevator control unit 7 by means of electrical lines, which are not shown in Fig. 1, in particular by an electric bus, or by means of wireless connections.

The elevator system 1 further comprises an emergency power supply 20 which is configured for providing power in case of a failure of external power supply. An electrical system 2 of the elevator system 1 comprises the emergency power supply 20, the elevator control 7 and the elevator drive 5.

The power provided by the emergency power supply 20 should be sufficient for bringing the elevator system 1 into a safe state in an automatic rescue operation, "ARO", e.g. for moving the elevator car 6 to one of the landings 8 and opening the elevator car door 12 and the landing door 10 in order to allow passengers to leave the elevator car 6 in an emergency situation in which the external power supply is disturbed or cut off. In an alternative embodiment, the power provided by the emergency power supply 20 should be sufficient at least for operating a communication system (not shown) which allows passengers trapped within the elevator car 6 to communicate with service personnel residing outside the elevator car 6.

The emergency power supply 20 comprises a battery 24 which is configured for storing electrical energy to be supplied in emergency situations, in particular in case of a disturbance or failure of external power supply. The emergency power supply 20 further comprises a charger circuit 26, which is configured for charging the battery 24 with electrical energy supplied by an external power source 28, e.g. an electric power supply network.

The emergency power supply 20 also comprises a battery monitoring device 22, which is electrically connected to the battery 24 and the charger circuit 26 and which is configured for monitoring the charging and discharging of the battery 24 and for determining the current charging state of the battery 24.

The battery monitoring device 22 in particular is configured for setting an initial numerical value representing the charging state of the battery 24 after a fully charged battery 24 has been added to the emergency power supply 20. The initial numerical value may be provided by the manufacturer of the battery 24 or it may be determined experimentally, e.g. by performing a load test with the battery 24. In this case the initial numerical value may be set at any desired time, e.g. when measuring the charging state of the battery 24 during a maintenance procedure.

During the following operation of the elevator system 1, starting from the initial numerical value, an updated numerical value representing the current charging state of the battery 24 is repeatedly calculated from the respective numerical value which has been calculated previously by:
determining the current operational state of the electrical system 2 and a time period T₁ - T₁₀ for which said determined current operational state is active;
calculating a change of the charging state of the battery 24 as a function of the determined current operational state of the electrical system 2 and the time period T₁ - T₁₀ for which said current operational state has been active; and
updating the previously calculated (or initial) numerical value representing the charging state of the battery 24 by adding or subtracting the calculated change of the charging state to/from the previously calculated (or initial) numerical value.

In consequence, the procedure provides a current numerical value representing the charging state of the battery, i.e. the amount of charge stored within the battery 24, at any given moment.

The battery monitoring device 22 is configured for issuing an alarm signal in case the current numerical value representing the charging state of the battery 24 falls below a predetermined threshold Th₁,Th₂. Said alarm signal might trigger a service call requesting a field mechanic to visit the elevator system 1 for checking the electrical installation and/or replacing the battery 24. Alternatively or additionally, the alarm signal might result in stopping further operation of the elevator system 1, in particular in case the amount of charge stored within the battery 24 is not sufficient for allowing to run an automatic rescue operation (ARO) in case the external power supply 28 breaks down.

In particular, a service call might be triggered in case the current numerical value representing the charging state of the battery 24 falls below a predetermined first threshold Th₁, and any further operation of the elevator system 1 may be stopped in case the current numerical value representing the charging state of the battery 24 falls below a predetermined second threshold Th₂, which is smaller than the first threshold Th₁.

In order to avoid passengers from being trapped within the elevator car 6, the elevator car 6 may be moved to one of the landings 8 and the landing door 10 and the elevator car door 12 may be opened before any further operation of the elevator system 1 is stopped.

The function which is used for calculating the change of the charging state of the battery 24 in dependency of the determined operational state of the electrical system may be a linear or a non-linear function of time.

The function in particular may be a linear function of time comprising a factor which depends on the determined operational state of the electrical system 2 and which is multiplied with the period of time for which the respective determined operational state of the electrical system 2 has been active since the previously determined charging state.

Thus, each factor may represent the specific power consumption per time or charging rate, which is characteristic for the respective operational state.

The operational states of the electrical system 2 may in particular include:
at least one charging state, in which the battery 24 is charged by supplying an electrical current from the external power supply 28;
at least one discharging state, in which the battery 24 is externally discharged by operating the electrical system 2 with an electrical current supplied by the battery 24; and
an idle state, in which the battery 24 is neither in the charging state nor in the discharging state, but in which the battery 24 gradually discharges due to self-discharge.

In the idle state, the battery 24 gradually discharges due to self-discharge. The id state also may include a trickle charging state, in which only a trickle charging current is applied.

Usually a different function/factor is assigned to each of these states. Other charging states and discharging states are conceivable.

The battery 24 comprises a maximum charging state, which is a characteristics of the specific battery 24 and which corresponds to the capacity of the battery 24. Aging of the battery 24 results in a decrease of battery capacity, i.e. the maximum possible charging state of the battery 24, over time. The aging of the battery 24 may be taken into account by employing an aging function, which limits the maximum charge of the battery 24 as a function of time. Said aging function may be provided by the manufacturer of the battery 24. Alternatively, the aging function may be based on information provided by the manufacturer of the battery 24 or it may be based on experimental data. For example, the maximum possible charging state of the battery 24 may be measured during maintenance procedures.

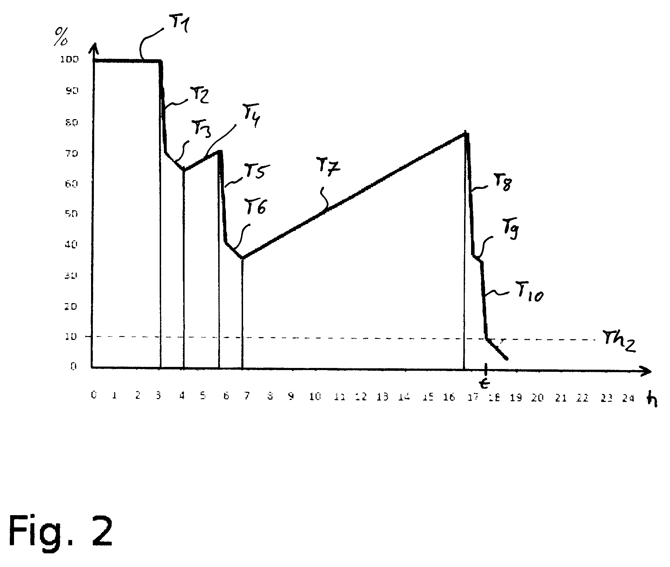

Figure 2 exemplary illustrates a change of the charging state of the battery 24 over time as it is determined employing embodiments of the present invention.

In a first time period T₁ a completely loaded battery 24 is connected to the charger circuit 26. As a result, the charging state of the battery 24 stays constant at 100%.

During a second time period T₂, an automatic rescue run (ARO) of the elevator system 1 is performed. The ARO discharges the battery 24 resulting in a charging state of approximately 70%. In a following idle state during a third time period T₃, the charging state drops further to approximately 65%.

In a fourth time period T₄ the battery 24 is charged by means of the charger circuit 26 resulting in an increase of the charging state to approximately 70%.

Due to a further ARO during a fifth time period T₅, the charging state drops to approximately 40%. This is followed by another idle state (time period T₆) which results in a charging state of approximately 35%.

In a following seventh time period T₇ the battery 24 is charged again up to a charging state to approximately 75%.

Afterwards, the battery 24 is discharged by two automatic rescue runs (ARO) (T₈ and T₁₀) with a short period T₉ of idle time in between.

At the end t of the tenth time period T₁₀ the charging state of the battery 24 drops below 10%, which has been defined as the minimum threshold Th₂ necessary for ensuring a secure ARO. In consequence, the operation of the elevator system 1 is stopped; and no further operation is possible until the battery 24 has been reloaded to a charging state of more than 10%.

The graph shown in Figure 2 is based on a linear model of the charging operations and of the discharging operations, wherein different constant factors are assigned to each of states, i.e. to the charging state, to the discharging state in which the ARO is run, and to the idle state, respectively.

The influence of the aging of the battery 24 is not illustrated in Figure 2, as it is negligible over the relatively short total time period of 24h depicted in Figure 2.

A number of optional features are set out in the following. These features may be realized in particular embodiments, alone or in combination with any of the other features.

In one embodiment the repeatedly performed steps may be performed periodically, i.e. at constant time intervals. In an alternative embodiment, the repeatedly performed steps may be performed at varying time intervals, e.g. every time the operational state of the electrical system is changed.

In one embodiment the function which is employed for calculating the change of the charging state may be a product of a factor associated with the determined operational state and the corresponding time period. A linear model, in which the change of the charging state is a product of a factor associated with the determined operational state and the corresponding time period, provides the current charging state with low effort and sufficient accuracy.

In one embodiment the method further comprises issuing an alarm signal in case the numerical value representing the charging state of the battery is below a first predetermined threshold. The alarm signal in particular may be issued in case the numerical value representing the charging state of the battery is below the predetermined first threshold for more than a predetermined time period. The alarm signal in particular may result in a mechanic visiting the site for checking and/or replacing the battery in order to restore the full functionality and capacity of the battery.

In one embodiment the method may comprise stopping any further operation of the electrical system in case the numerical value representing the charging state of the battery is below a predetermined second threshold. The second threshold in particular may be lower than the first threshold. Stopping any further operation of the electrical system avoids operating the electrical system in a situation in which the battery does not comprise enough charge for securing safe operation in case of power failure. In consequence, the operational safety may be enhanced.

In one embodiment the method may comprise limiting the numerical value representing the maximum charging state of the battery as a function of time. This allows an even more accurate determination of the current charging state of the battery as the aging of the battery, which results in a decrease of its capacity over time, is taken into account.

In one embodiment the operational states of the electrical system may include one or more of: a charging state, in which the battery is charged by supplying an electrical current from an external source; a discharging state, in which the battery is externally discharged by operating the electrical system with an electrical current which is supplied by the battery; and an idle state, in which the battery is neither in the charging state nor in the discharging state. I.e. in the idle state, the battery is not charged and no load is connected to the battery. In particular, a different factor may be assigned to each of these states in order to allow for an accurate determination of the current charging state of the battery. In further embodiments the electrical system may include more than three states, e.g. different charging states corresponding to different charging currents and/or different discharging states, which correspond to different discharging currents resulting from different operational states of the electrical system, respectively. There also may be different idle states. Different idle states e.g. may correspond to different temperature ranges taking into account the effect that the self-discharging may be influenced by the temperature of the battery.

In one embodiment the electrical system may be an elevator rescue system and the method may comprise a discharging state in which the elevator rescue system is driven by an electrical current supplied by the battery. This allows to ensure the operating ability of the elevator rescue system enhancing the safety of the elevator system.

Exemplary embodiments of the invention also include an elevator system comprising at least one elevator car which is configured for travelling along a hoistway; and an electrical system according to an exemplary embodiment of the invention. This provides an elevator system having a high operational security as it is ensured that the elevator system is operated if the battery comprises enough charge for performing an elevator rescue run in case of an external power failure.

While the invention has been described with reference to exemplary embodiments, it will be understood by those skilled in the art that various changes may be made and equivalents may be substituted for elements thereof without departing from the scope of the invention. In addition many modifications may be made to adopt a particular situation or material to the teachings of the invention without departing from the essential scope thereof. Therefore, it is intended that the invention not be limited to the particular embodiment disclosed, but that the invention include all embodiments falling within the scope of the dependent claims.

### References

- 1: elevator system
- 2: electrical system
- 3: tension member
- 4: hoistway
- 5: drive
- 6: elevator car
- 7: elevator control unit
- 8: landing
- 9: ceiling of the elevator car
- 10: landing door
- 12: elevator car door
- 14: elevator car control panel
- 16: landing control panel
- 20: emergency power supply
- 22: battery monitoring device
- 24: battery
- 26: charger circuit
- 28: external power supply

## Claims

1. Method of monitoring a charging state of a battery (26) in an electrical system (2); the method comprising the steps of:
setting a numerical value representing the charging state of the battery (26) to an initial numerical value; and repeatedly:
determining a current operational state of the electrical system (2) and a time period (T₁ - T₁₀) for which said current operational state is active;
calculating a change of the charging state as a function of the determined current operational state of the electrical system (2) and the time period (T₁ - T₁₀) for which said current operational state is active; and
updating the numerical value representing the charging state of the battery (26) by adding or subtracting the calculated change of the charging state to/from the numerical value.

2. Method according to claim 1, wherein the function used for calculating the change of the charging state is a product of a factor associated with the determined current operational state and the corresponding time period (T₁ - T₁₀).

3. Method according to any of the previous claims, further comprising the step of issuing an alarm signal in case the numerical value representing the charging state of the battery (26) is below a predetermined first threshold (Th₁).

4. Method according to any of the previous claims, wherein the method further comprises stopping further operation of the electrical system (2) in case the numerical value representing the charging state of the battery (26) is below a predetermined second threshold (Th₂).

5. Method according to any of the previous claims, further comprising the step of limiting the value representing the maximum charging state of the battery (26) as a function of time.

6. Method according to any of the previous claims, wherein the current operational states of the electrical system (2) include one or more of:
a charging state, in which the battery (26) is charged by supplying an electrical current from an external power supply (28);
a discharging state, in which the battery (26) is externally discharged by operating the electrical system (2) using an electrical current supplied by the battery (26); and
an idle state, in which the battery (26) is neither in the charging state nor in the discharging state.

7. Method according to any of the previous claims, wherein the electrical system (2) is an elevator rescue system and the method comprises a discharging state in which the elevator rescue system is driven by an electrical current supplied by the battery (26).

8. Electrical system (2) comprising:
a battery (26) for storing electrical energy;
a battery monitoring device (22) which is configured for determining a numerical value representing the charging state of the battery (26) by
setting a numerical value representing the charging state of the battery (26) to an initial value; and repeatedly:
determining a current operational state of the electrical system (2) and a time period (T₁ - T₁₀) for which said current operational state is active;
calculating a change of the charging state of the battery (26) as a function of the determined current operational state of the electrical system (2) and the time period (T₁ - T₁₀) for which said current operational state is active; and
updating the numerical value representing the charging state of the battery (26) by adding or subtracting the calculated change of the charging state to/from the numerical value.

9. Electrical system (2) according to claim 8, wherein the function used for calculating the change of the charging state is a product of a factor associated with the determined current operational state and the corresponding time period (T₁ - T₁₀).

10. Electrical system (2) according to claim 8 or 9, wherein the battery monitoring device (22) is configured for issuing an alarm signal in case the numerical value representing the current charging state of the battery (26) is below a predetermined threshold (Th₁, Th₂).

11. Electrical system (2) according to any of claim 8 to 10, wherein the battery monitoring device (22) is further configured for limiting the maximum value representing the current charging state of the battery (26) as a function of time.

12. Electrical system (2) according to any of claims 8 to 11, wherein the current operational states of the electrical system (2) include one or more one of:
a charging state, in which the battery (26) is charged by supplying an electrical current from an external power supply (28);
a discharging state, in which the battery (26) is externally discharged by operating the electrical system (2) using an electrical current supplied by the battery (26); and
an idle state, in which the battery (26) is neither in the charging state nor in the discharging state.

13. Electrical system (2) according to any of claims 8 to 12, wherein the electrical system (2) is an elevator rescue system comprising a discharging state in which the elevator rescue system is driven by an electrical current supplied by the battery.

14. Elevator system (1) comprising:
at least one elevator car (6) which is configured for traveling along a hoistway (4) between a plurality of landings (8); and
an electrical system (2) according to claim 13.

15. Elevator system (1) according to claim 14, which is configured for issuing a maintenance call in case the determined charging state of the battery (26) is below a predetermined first threshold (Th₁) and/or for moving the at least one elevator car (6) to one of the landings (8), opening any doors (10, 12) of the elevator car (6) and stopping any further operation of the elevator system (1) in case the determined charging state of the battery (26) is below a predetermined second threshold (Th₂).
